# EUROPEAN PATENT APPLICATION

(11) **EP 4 730 070 A1**
(43) Date of publication of application: **22.04.2026**
(21) Application number: 24843377.3
(22) Date of filing: 03.07.2024
(51) Int. Cl.: G06F 1/16, C03C 17/23, C08J 7/04, G02B 5/30

(54) **COVER AND ELECTRONIC DEVICE INCLUDING COVER**

(30) Priority: 17.07.2023 KR 20230092718; 26.07.2023 KR 20230097622
(71) Applicant: Samsung Electronics Co., Ltd., Suwon-si, Gyeonggi-do 16677 (KR)
(72) Inventor: SIN, Wanju, Suwon-si, Gyeonggi-do 16677 (KR); KIM, Hakju, Suwon-si, Gyeonggi-do 16677 (KR); PARK, Gijea, Suwon-si, Gyeonggi-do 16677 (KR); CHOI, Jongmun, Suwon-si, Gyeonggi-do 16677 (KR); CHOI, Hyunsuk, Suwon-si, Gyeonggi-do 16677 (KR)
(74) Representative: Walaski, Jan Filip
(86) International application number: PCT/KR2024/009411
(87) International publication number: WO 2025/018658

(57) **Abstract**

The present disclosure relates to an electronic device. An electronic device according to an embodiment of the present disclosure includes: a display; and a housing including a support member on which the display is mounted and a cover forming at least a portion of the exterior of the electronic device, wherein the cover may include: a glass layer; a first color layer disposed between the glass layer and the support member and having a first color; a second color layer that is disposed at a position opposite to the first color layer with respect to the glass layer and has a second color complementary to the first color.

## Description

### [Technical Field]

Various embodiments disclosed herein relate to an electronic device, for example, an electronic device including a cover.

### [Background Art]

With the remarkable development of information communication technology, semiconductor technology, and the like, the distribution and use of various electronic devices are rapidly increasing. In particular, recent electronic devices are being developed to be portable and capable of communication.

The term "electronic device" may refer to a device that performs a specific function according to an installed program, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images. As the degree of integration of electronic devices increases and ultra-high-speed and high-capacity wireless communication become more widespread, a single electronic device, such as a mobile communication terminal, may be now equipped with various functions. For example, not only communication functions but also entertainment functions such as gaming, multimedia functions such as music and video playback, communication and security functions such as mobile banking, as well as schedule management and electronic wallet functions, are being integrated into a single electronic device. Such an electronic device is being miniaturized to allow a user to conveniently carry it.

### [Detailed Description of the Invention]

### [Technical Solution]

According to an embodiment of the disclosure, an electronic device may include a display, and a housing including a supporting member on which the display is seated and a cover forming at least a portion of an exterior of the electronic device. The cover may include a glass layer, a first color layer disposed between the glass layer and the supporting member and having a first color, and a second color layer disposed at a position opposite to the first color layer with respect to the glass layer and having a second color that is complementary to the first color.

According to an embodiment of the disclosure, the cover may include a glass layer, a first color layer disposed between the glass layer and the supporting member and having a first color, and a second color layer disposed at a position opposite to the first color layer with respect to the glass layer and having a second color that is complementary to the first color.

### [Brief Description of Drawings]

FIG. 1 is a block diagram of an electronic device according to various embodiments in a network environment.
FIG. 2 is a perspective view of an electronic device according to an embodiment of the disclosure.
FIG. 3 is a perspective view illustrating the electronic device according to an embodiment of the disclosure.
FIG. 4 is an exploded perspective view of the electronic device according to an embodiment of the disclosure.
FIG. 5 is an exploded perspective view of the electronic device according to an embodiment of the disclosure.
FIG. 6 is a partial cross-sectional view of a cover according to an embodiment of the disclosure.
FIG. 7 is a partial cross-sectional view of a cover according to an embodiment of the disclosure.
FIG. 8 is a partial cross-sectional view of a cover according to an embodiment of the disclosure.
FIG. 9 is a conceptual view illustrating a method of fabricating a cover according to an embodiment of the disclosure.
FIG. 10A is a view illustrating a complementary-color relationship according to an embodiment of the disclosure.
FIG. 10B is a view illustrating a variable color of a cover according to an embodiment of the disclosure.
FIG. 10C is a view illustrating reflection of light in a cover according to an embodiment of the disclosure.
FIG. 11 is a partial cross-sectional view of a cover according to an embodiment of the disclosure.
FIG. 12 is a view illustrating a pattern of a cover according to an embodiment of the disclosure.
FIG. 13 is a partial cross-sectional view of a cover according to an embodiment of the disclosure.
FIG. 14 is a view illustrating an electronic device according to an embodiment of the disclosure in an unfolded state.

### [Mode for Carrying out the Invention]

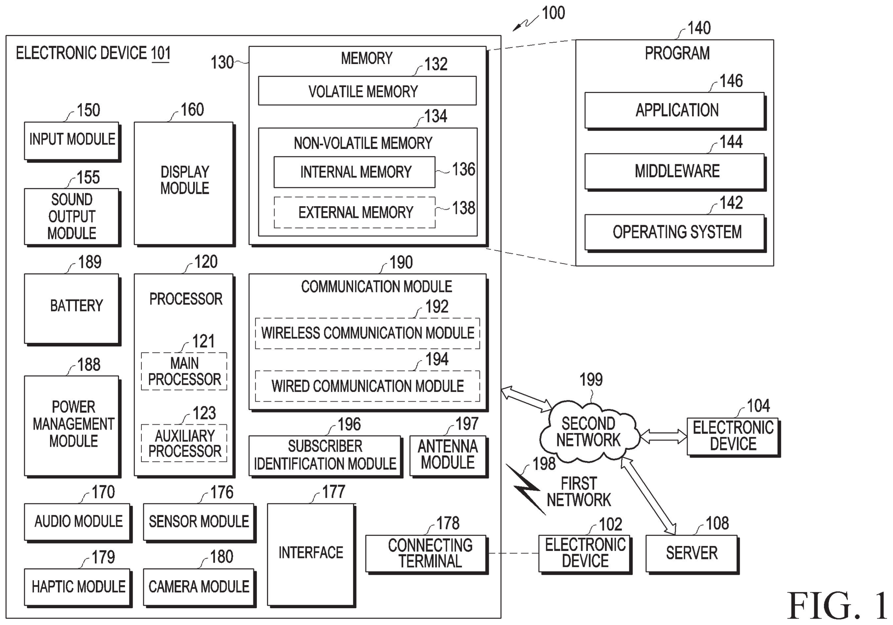

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

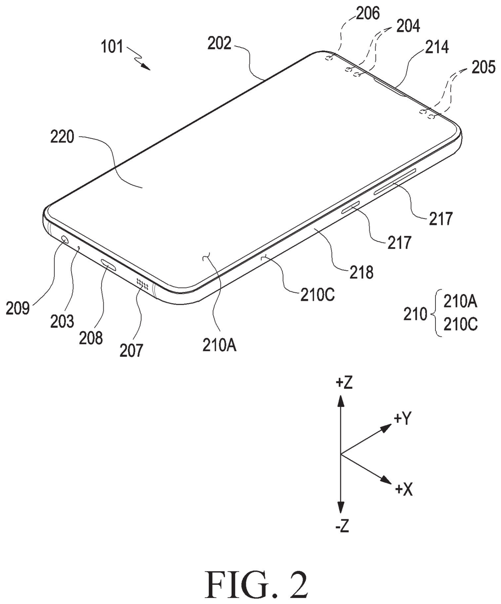

FIG. 2 is a front perspective view of an electronic device according to an embodiment of the disclosure.

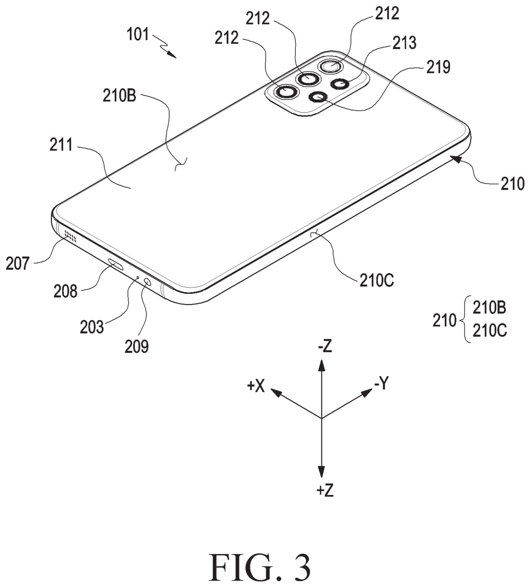

FIG. 3 is a rear perspective view of the electronic device according to an embodiment of the disclosure.

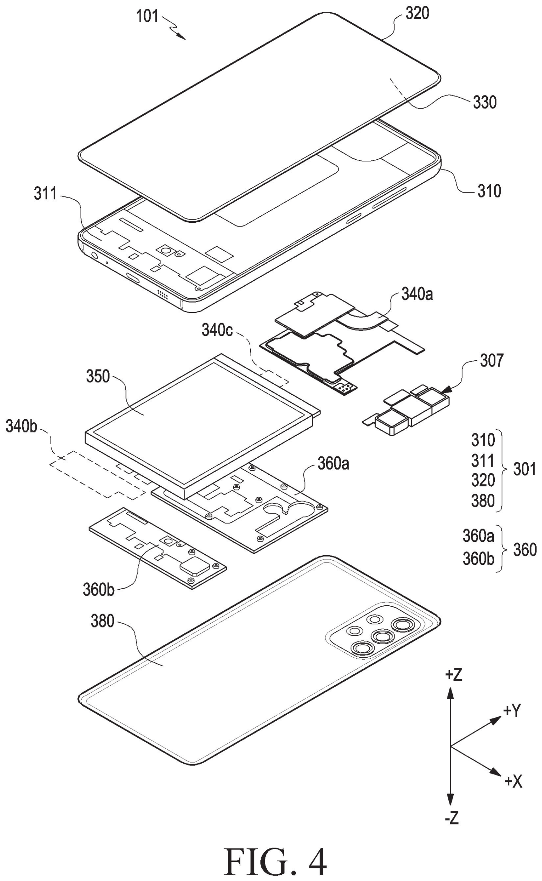

The embodiments of FIGS. 2 and 3 may be combined with the embodiment of FIG. 1 or the embodiments of FIGS. 4 to 11.

Referring to FIGS. 2 and 3, the electronic device 101 (e.g., the electronic device 101 in FIG. 1) according to an embodiment may include a housing 210 including a first surface (or front surface) 210A, a second surface (or rear surface) 210B, and a side surface 210C surrounding the space between the first surface 210A and the second surface 210B. In an embodiment (not illustrated), the housing 210 may refer to a structure that forms a portion of the first surface 210A of FIG. 2, and the second surface 210B and the side surface 210C of FIG. 3. According to an embodiment, at least a portion of the first surface 210A may be made of a substantially transparent front surface plate 202 (e.g., a glass plate or a polymer plate including various coating layers). The second surface 210B may be made of a substantially opaque rear surface plate 211. The rear surface plate 211 may be made of, for example, coated or colored glass, ceramic, polymer, metal (e.g., aluminum, stainless steel (STS), or magnesium), or a combination of two or more of these materials. The rear surface plate 211 may be referred to as a "plate." The rear surface plate 211 may be referred to as a "cover." The cover 211 may form the second surface 210B. The cover 211 may have a color that varies depending on a viewing angle. The side surface 210C may be defined by the side surface structure (or a "side surface bezel structure") 218 coupled to the front surface plate 202 and the rear surface plate 211 and including metal and/or polymer. In an embodiment, the rear surface plate 211 and the side surface structure 218 may be integrated with each other and may include the same material (e.g., a metal material such as aluminum).

Although not illustrated, the front surface plate 202 may include one or more regions that are curved and extend seamlessly from at least a portion of an edge toward the rear surface plate 211. In an embodiment, the front surface plate 202 (or the rear surface plate 211) may include only one of the regions bent and extending toward the rear surface plate 211 (or the front surface plate 202), at one side edge of the first surface 210A. According to an embodiment, the front surface plate 202 or the rear surface plate 211 may be substantially flat in shape. For example, the front or rear surface plate may not include a region that is curved and extended. When the bent and extending region is included, the thickness of the electronic device 101 in the portion including the bent and extending region may be smaller than the thicknesses of other portions.

According to an embodiment, the electronic device 101 may include at least one of a display 220, audio modules 203, 207, and 214, sensor modules 204 and 219, camera modules 205, 212, and 213, key input devices 217, light-emitting elements 206, and connector holes 208 and 209. In an embodiment, at least one of the components (e.g., the key input devices 217 or the light-emitting element 206) may be omitted from the electronic device 101 or other components may be additionally included.

The display 220 may be visually exposed through a substantial portion of, for example, the front surface plate 202. In an embodiment, at least a portion of the display 220 may be visually exposed through the front surface plate 202 forming the first surface 210A or through a portion of the side surface 210C. In an embodiment, the edge of the display 220 may be formed to be substantially the same as the shape of the periphery of the front surface plate 202 adjacent thereto. In an embodiment (not illustrated), the distance between the periphery of the display 220 and the periphery of the front surface plate 202 may be substantially constant in order to increased the visually exposed area of the display 220.

In an embodiment (not illustrated), recesses or openings may be provided in some portions of the screen display region of the display 220, and one or more of the audio module 214, the sensor module 204, the camera module 205, and the light-emitting elements 206 may be aligned with the recesses or the openings. In an embodiment (not illustrated), the rear surface of the screen display region of the display 220 may include at least one of the audio module 214, the sensor modules 204, the camera modules 205, a fingerprint sensor (not illustrated), and the light-emitting elements 206. In an embodiment (not illustrated), the display 220 may be coupled to or disposed adjacent to a touch-sensitive circuit, a pressure sensor capable of measuring a touch intensity (pressure), and/or a digitizer configured to detect an electromagnetic field-type stylus pen. In an embodiment, at least some of the sensor modules 204 and 219 and/or at least some of the key input devices 217 may be disposed in the first regions 210D and/or the second regions 210E.

The audio modules 203, 207, and 214 may include a microphone hole 203 and speaker holes 207 and 214. A microphone configured to acquire external sound may be placed inside the microphone hole 203, and in an embodiment, multiple microphones may be placed to detect the direction of sound. The speaker holes 207 and 214 may include an external speaker hole 207 and a communication receiver hole 214. In an embodiment, the speaker holes 207 and 214 and the microphone hole 203 may be implemented as a single hole, or a speaker (e.g., a piezo speaker) may be included without the speaker holes 207 and 214.

The sensor modules 204 and 219 may generate electrical signals or data values corresponding to an internal operating state or an external environmental state of the electronic device 101. The sensor modules 204 and 219 may include, for example, a first sensor module 204 (e.g., a proximity sensor) and/or a second sensor module (not illustrated) (e.g., a fingerprint sensor) disposed on the first surface 210A of the housing 210, and/or a third sensor module 219 and/or a fourth sensor module (e.g., a fingerprint sensor) disposed on the second surface 210B of the housing 210. The fingerprint sensor may be disposed not only on the first surface 210A (e.g., the display 220), but also on the second surface 210B or the side surface 210C of the housing 210. The electronic device 101 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 205, 212, and 213 may include a first camera device 205 disposed on the first surface 210A of the electronic device 101, and a second camera device 212 and/or a flash 213 disposed on the second surface 210B. The camera devices 205 and 212 may include one or more lenses, an image sensor, and/or an image signal processor. The flash 213 may include, for example, a light-emitting diode or a xenon lamp. In an embodiment, two or more lenses (e.g., an infrared camera lens, a wide-angle lens, and a telephoto lens) and image sensors may be disposed on one surface of the electronic device 101. In an embodiment, the flash 213 may emit infrared rays, and the infrared light emitted by the flash 213 and reflected by a subject may be received through the third sensor module 219. The electronic device 101 or a processor of the electronic device 101 may detect depth information of a subject based on a time point when the infrared light received by the third sensor module 219.

The key input devices 217 may be disposed on the side surface 210C of the housing 210. In an embodiment, the electronic device 101 may not include some or all of the above-described key input devices 217, and the key input devices 217 not included may be implemented in another form, such as soft keys, on the display 220. In an embodiment, the key input devices may include a sensor module disposed on the second surface 210B of the housing 210.

The light-emitting elements 206 may be disposed, for example, on the first surface 210A of the housing 210. The light-emitting elements 206 may provide, for example, the state information of the electronic device 101 in an optical form. In an embodiment, the light-emitting elements 206 may provide, for example, a light source that operates in conjunction with the camera module 205. The light-emitting elements 206 may include, for example, an LED, an IR LED, and a xenon lamp.

The connector holes 208 and 209 may include a first connector hole 208 capable of accommodating a connector (e.g., a USB connector) configured to transmit/receive power and/or data to/from an external electronic device, and/or a second connector hole (e.g., an earphone jack) 209 capable of accommodating a connector configured to transmit/receive an audio signal to/from an external electronic device.

FIG. 4 is a front exploded perspective view of the electronic device according to an embodiment of the disclosure.

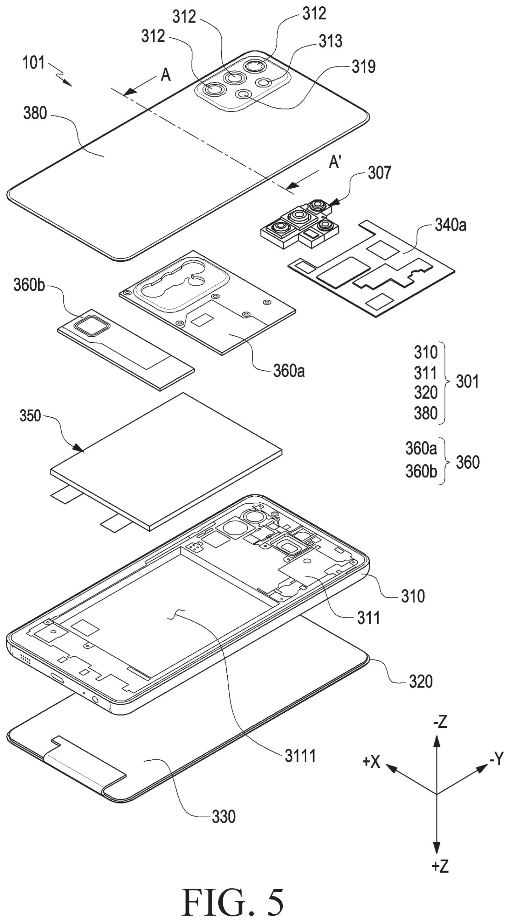

FIG. 5 is a rear exploded perspective view of the electronic device according to an embodiment of the disclosure.

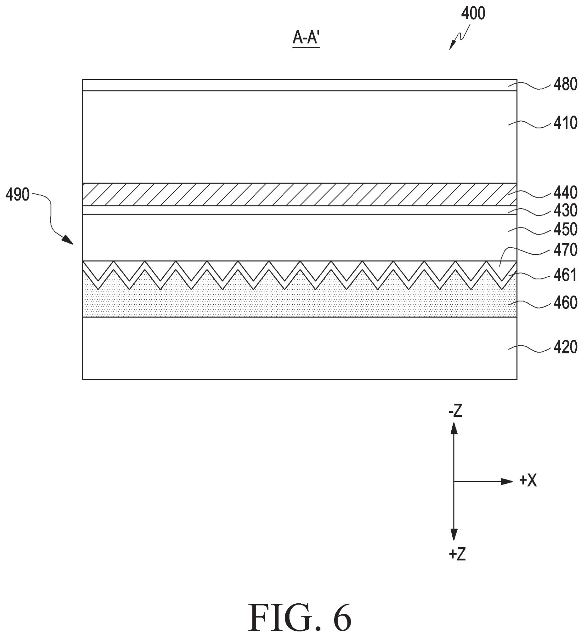

The embodiments of FIGS. 4 and 5 may be combined with the embodiments of FIGS. 1 to 3 or the embodiments of FIGS. 6 to 11.

Referring to FIGS. 3 and 4, the electronic device 101 (e.g., the electronic device 101 in FIG. 1 or FIG. 2) may include a side surface structure 310, a first support member 311 (e.g., a bracket), a front surface plate 320 (e.g., the front surface plate 202 in FIG. 1), a display 330 (e.g., the display 220 in FIG. 1), one or more printed circuit boards (or substrate assemblies) 340a and 340b, a battery 350, a second support member 360 (e.g., a rear case), an antenna, a camera assembly 307, and a rear surface plate 380 (e.g., the rear surface plate 211 in FIG. 2). When including multiple printed circuit boards 340a and 340b, the electronic device 101 may include at least one flexible printed circuit board 340c to electrically connect different printed circuit boards. For example, the printed circuit boards 340a and 340b may include a first circuit board 340a disposed above the battery 350 (e.g., in the +Y-axis direction) and a second circuit board 340b disposed below the battery 350 (e.g., in the -Y-axis direction), and a flexible printed circuit board 340c may electrically connect the first circuit board 340a and the second circuit board 340b.

According to an embodiment, at least one of the components (e.g., the first support member 311 or the second support member 360) may be omitted from the electronic device 101, or may additionally include other components. At least one of the components of the electronic device 101 may be the same as or similar to at least one of the components of the electronic device 101 illustrated in FIG. 1 or FIG. 2, and redundant descriptions are omitted below.

The first support member 311 may be provided such that at least a portion thereof has a flat plate shape. In an embodiment, the first support member 311 may be disposed inside the electronic device 101 to be connected to the side surface structure 310 or may be integrated with the side surface structure 310. The first support member 311 may be made of, for example, a metal material and/or a non-metal (e.g., polymer) material. When the first support member 311 is at least partially made of a metal material, a portion of the side surface structure 310 or the first support member 311 may serve as an antenna. The first support member 311 may include one surface to which the display 330 is coupled and the other surface to which the printed circuit boards 340a and 340b are coupled. A processor, memory, and/or an interface may be mounted on the printed circuit boards 340a and 340b. The processor may include, for example, one or more of a central processing unit, an application processor, a graphics processing unit, an image signal processor, a sensor hub processor, or a communication processor.

According to an embodiment, the housing 301 may include a first support member 311 and a side surface structure 310. According to an embodiment, the housing 301 may be understood as a structure for accommodating, protecting, or disposing the printed circuit boards 340a and 340b, or the battery 350. In an embodiment, it may be understood that the housing 301 includes structures capable of being visually or tactually recognized by a user in the exterior of the electronic device 101, such as the side surface structure 310, the front surface plate 320, and/or the rear surface plate 380. For example, the housing 301 may include structures forming an exterior of the electronic device 101 (e.g., the side surface structure 310, the front surface plate 320, and the rear surface plate 380). The housing 301 may be the same as the housing 210 described with reference to FIGS. 2 and 3. In an embodiment, the "front surface or rear surface of the housing 301" may refer to the first surface 210A in FIG. 1 or the second surface 210B in FIG. 2. In an embodiment, the first support member 311 may be disposed between the front surface plate 320 (e.g., the first surface 210A in FIG. 1) and the rear surface plate 380 (e.g., the second surface 210B in FIG. 2) and may serve as a structure on which electrical/electronic components, such as the printed circuit boards 340a and 340b or the camera assembly 307, are arranged.

The memory may include, for example, volatile memory or non-volatile memory.

The interface may include, for example, a high-definition multimedia interface (HDMI), a universal serial bus (USB) interface, an SD card interface, and/or an audio interface. The interface may electrically or physically connect, for example, the electronic device 101 to an external electronic device, and may include a USB connector, an SD card/MMC connector, or an audio connector.

The second support member 360 may include, for example, an upper support member 360a or a lower support member 360b. In an embodiment, the upper support member 360a may be disposed to enclose the printed circuit board 340a or 340b (e.g., the first circuit board 340a) together with a portion of the first support member 311. For example, the upper support member 360a of the second support member 360 may be disposed to face the first support member 311 with the first circuit board 340a interposed therebetween. In an embodiment, the lower support member 360b of the second support member 360 may be disposed to face the first support member 311 with the second circuit board 340b interposed therebetween. Integrated circuit devices implemented in the form of integrated circuit chips (e.g., a processor, a communication module, or memory) and various electrical or electronic components may be disposed on the printed circuit boards 340a and 340b. In an embodiment, the printed circuit boards 340a and 340b may be provided with an electromagnetic shielding environment from the second support member 360. In an embodiment, the lower support member 360b may serve as a structure for positioning electric/electronic components such as a speaker module or an interface (e.g., a USB connector, an SD card/MMC connector, or an audio connector). In an embodiment, an electrical/electronic component, such as a speaker module or an interface (e.g., a USB connector, an SD card/MMC connector, or an audio connector), may be disposed on an additional printed circuit board (not illustrated). For example, the lower support member 360b may be disposed to surround an additional printed circuit board (e.g., the second printed circuit board 340b) together with another portion of the first support member 311. A speaker module or an interface disposed on the additional printed circuit board (not illustrated) or the lower support member 360b may be disposed to correspond to the audio module 207 or the connector holes 208 and 309 in FIG. 1.

The battery 350 may serve as a device that supplies power to at least one component of the electronic device 101, and may include, for example, a non-rechargeable primary cell, a rechargeable secondary cell, or a fuel cell. At least a portion of the battery 350 may be disposed on substantially the same plane as, for example, the printed circuit boards 340a and 340b. The battery 350 may be integrally disposed inside the electronic device 101 or may be detachably disposed with respect to the electronic device 101.

Although not illustrated, the antenna may include a conductor pattern implemented on the surface of the second support member 360 through, for example, a laser direct structuring method. In an embodiment, the antenna may include a printed circuit pattern provided on the surface of a thin film, and the thin film-type antenna may be disposed between the rear surface plate 380 and the battery 350. The antenna may include, for example, a near-field communication (NFC) antenna, a wireless charging antenna, and/or a magnetic secure transmission (MST) antenna. The antenna may, for example, perform near-field communication with an external device, or wirelessly transmit and receive power required for charging. In an embodiment, an antenna structure may be configured with a portion or a combination of the side surface structure 310 and/or the first support member 311.

According to an embodiment, the camera assembly 307 may include at least one camera module. Inside the electronic device 101, the camera assembly 307 (or at least one camera module) may receive at least a portion of light incident through an optical hole or a camera window. In an embodiment, the camera assembly 307 may be disposed on the first support member 311 at a position adjacent to the printed circuit board 340a or 340b. In an embodiment, the camera module(s) of the camera assembly 307 may be generally aligned with any one of the camera windows, and may be at least partially surrounded by the second supporting member 360 (e.g., the upper supporting member 360a).

According to an embodiment, the rear surface plate 380 may be referred to as a "cover" or a "plate." The cover 380 may form at least a portion of a surface of the housing 301. The cover 380 may form an exterior of the housing 301. A user may perceive a color of the cover 380. A displayed color of the cover 380 may vary depending on a viewing angle.

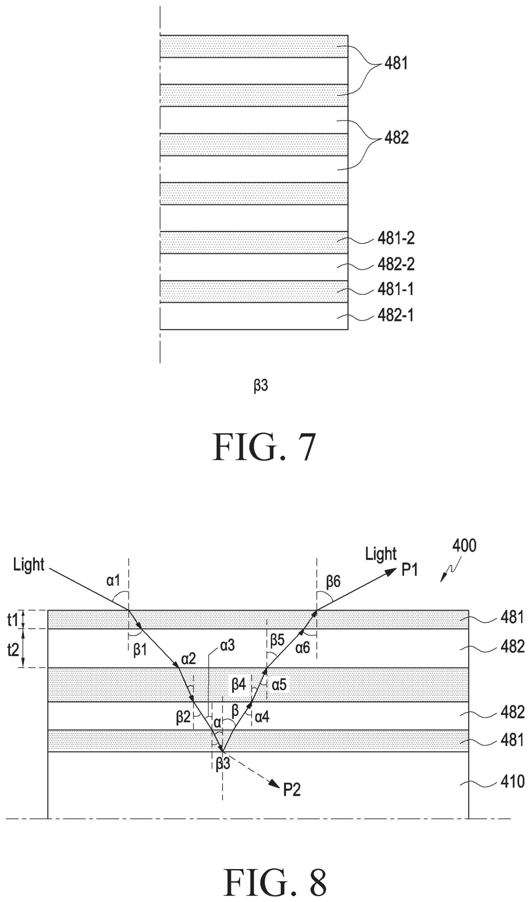

FIG. 6 is a partial cross-sectional view of the cover 380 taken along line A-A' illustrated in FIG. 5. The components to be described with reference to FIG. 6 may be partially or wholly the same as the components described with reference to FIGS. 1 to 5. For example, the description of the rear surface plate (e.g., the rear surface plate 380 of FIG. 5) described with reference to FIGS. 1 to 5 may be equally applied to the description of the cover 400 illustrated in FIG. 6. Components described with reference to FIG. 6 may be partially or entirely the same as components to be described with reference to FIGS. 7 to 14.

According to an embodiment, the cover 400 may include a glass layer 410. The glass layer 410 may include a ceramic material. The glass layer 410 may include a glass material. The glass layer 410 may be named a "base layer." The glass layer 410 may include a transparent material.

According to an embodiment, the cover 400 may include a shielding layer 420. The shielding layer 420 may include an opaque material. The shielding layer 420 may face an internal space of the housing (e.g., the housing 301 of FIG. 5). One surface of the shielding layer 420 may face the internal space of the housing (e.g., the housing 301 of FIG. 5). The shielding layer 420 may cover components (e.g., the battery 350 or the circuit board 360 of FIG. 5) disposed inside the housing (e.g., the housing 301 of FIG. 5). Components (e.g., the battery 350 or the circuit board 360 of FIG. 5) disposed inside the housing (e.g., the housing 301 of FIG. 5) may be invisible from the outside of the cover 400.

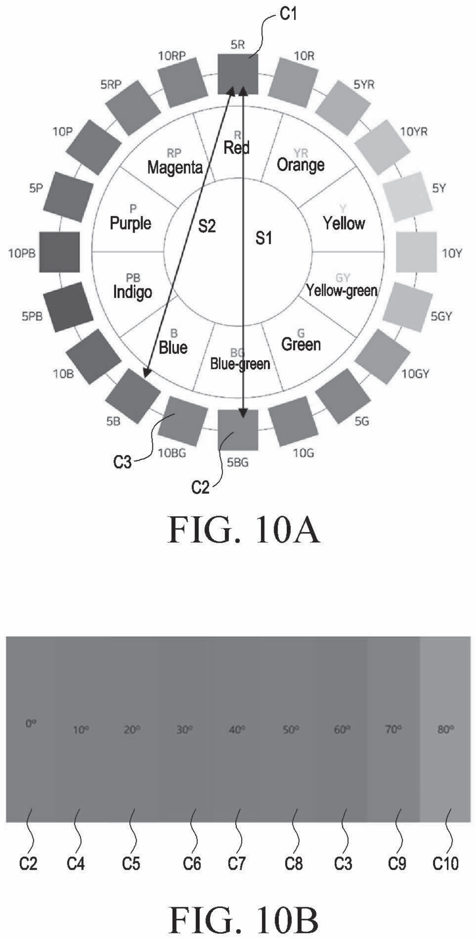

According to an embodiment, the cover 400 may include a color tint layer 430. The color tint layer 430 may be disposed between the glass layer 410 and the shielding layer 420. The color tint layer 430 may include a first color (e.g., the first color C1 of FIG. 10A).

According to an embodiment, the cover 400 may include an adhesive layer 440. The adhesive layer 440 may be disposed between the glass layer 410 and the color tint layer 430. The adhesive layer 440 may connect the glass layer 410 and the color tint layer 430. The adhesive layer 440 may include an optically clear adhesive (OCA) having a film shape.

According to an embodiment, the cover 400 may include a polymer layer 450. The polymer layer 450 may be disposed between the color tint layer 430 and the shielding layer 420. The polymer layer 450 may include a PET material. The polymer layer 450 may include a first color (e.g., the first color C1 of FIG. 10A). The polymer layer 450 may have the same color as the color tint layer 430. However, the polymer layer 450 may include a different color from the color tint layer 430, or may include a transparent material.

According to an embodiment, the cover 400 may include a color-printed layer 460. The color-printed layer 460 may be disposed between the polymer layer 450 and the shielding layer 420. The color-printed layer 460 may include a first color (e.g., the first color C1 of FIG. 10A). The color-printed layer 460 may include the same color as the color tint layer 430. However, the color-printed layer 460 may include a different color from the color tint layer 430, or may include a transparent material. The color-printed layer 460 may include a haze-processed surface. The haze-processed surface of the color-printed layer 460 may face the polymer layer 450.

According to an embodiment, the cover 400 may include a molded layer 461. The molded layer 461 may be applied to the haze-processed surface of the color-printed layer 460. The molded layer 461 may be disposed between the polymer layer 450 and the color-printed layer 460.

According to an embodiment, the cover 400 may include a deposition layer 470. The deposition layer 470 may be disposed between the molded layer 461 and the polymer layer 450. The deposition layer 470 may include a surface corresponding to a surface shape of the haze-processed color-printed layer 460.

According to an embodiment, the cover 400 may include a second color layer 480. The second color layer 480 may be coupled to the glass layer 410. The second color layer 480 may be disposed on an outer side the housing (e.g., the housing 301 of FIG. 5) relative to the glass layer 410. The second color layer 480 may form a surface of the cover 400. However, the cover 400 according to an embodiment disclosed herein may further include a reinforcing layer (not illustrated) coupled to the second color layer 480, and the reinforcing layer (not illustrated) may form a surface of the cover 400. The second color layer 480 may be referred to as a "deposition layer." The second color layer 480 may be referred to as a "light-receiving layer." The second color layer 480 may have a second color (e.g., the second color C2 of FIG. 10A). However, the second color may not indicate a fixed specific color. For example, the second color may correspond to any one of a plurality of colors (C2, C3, C4, C5, C6, C7, C8, C9, C10) illustrated in FIG. 10B. The second color may be a color that varies depending on an angle at which light is incident or reflected.

According to an embodiment, the cover 400 may include a first color layer having a first color (e.g., the first color C1 of FIG. 10A) and a second color layer 480 having a second color (e.g., the second color C2 of FIG. 10A). The first color layer may be at least one of the color tint layer 430, the polymer layer 450, and the color-printed layer 460 illustrated in FIG. 6. For example, all layers that include the first color (e.g., the first color C1 of FIG. 10A) among the color tint layer 430, the polymer layer 450, and the color-printed layer 460 may be defined as a "first color layer." The first color layer may include a plurality of layers (e.g., the color tint layer 430, the polymer layer 450, and the color-printed layer 460) spaced apart from one another. The second color layer 480 may include a second color (e.g., the second color C2 of FIG. 10A). The second color (e.g., the second color C2 of FIG. 10A) may be in a complementary color relationship with the first color (e.g., the first color C1 of FIG. 10A) of the first color layer. The first color layer may be located on an inner inside the housing (e.g., the housing 301 of FIG. 5) relative to the second color layer 480, and the second color layer 480 may form an exterior of the housing (e.g., the housing 301 of FIG. 5). The first color layer may be referred to as an "inner color layer," and the second color layer 480 may be referred to as an "outer color layer." The inner color layer 490 may include at least one of the color tint layer 430, the polymer layer 450, and the color-printed layer 460.

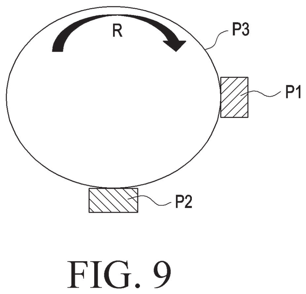

FIG. 7 is an enlarged view illustrating a portion of the second color layer 480. FIG. 8 is an enlarged view illustrating portions of the second color layer 480 and the glass layer 410. Components to be described with reference to FIGS. 7 and 8 may be partially or entirely the same as components described with reference to FIGS. 1 to 6. The components to be described with reference to FIGS. 7 and 8 may be partially or wholly the same as the components to be described with reference to FIGS. 9 to 14.

According to an embodiment, the second color layer 480 may include a first refractive layer 481. The second color layer 480 may include a second refractive layer 482. A refractive index of the first refractive layer 481 may be greater than a refractive index of the second refractive layer 482. A refractive index n1 of the first refractive layer 481 may range from 2.00 to 2.1. For example, the refractive index n1 of the first refractive layer 481 may be 2.05. A refractive index n2 of the second refractive layer 482 may range from 1.45 to 1.5. For example, the refractive index n2 of the second refractive layer 482 may be 1.46. The first refractive layer 481 may include silicon nitride (Si₃N₄). The second refractive layer 482 may include silicon oxide (SiO₂).

According to an embodiment, the second color layer 480 may be formed by alternately stacking a plurality of first refractive layers 481 and a plurality of second refractive layers 482. For example, each of the plurality of second refractive layers 482 may be disposed between every adjacent ones of the plurality of first refractive layers 481. For example, each of the plurality of first refractive layers 481 may be disposed between every adjacent ones of the plurality of second refractive layers 482. The first refractive layer 481 may include a (1-1)^{th} refractive layer 481-1 and a (1-2)^{th} refractive layer 481-2. The second refractive layer 482 may include a (2-1)^{th} refractive layer 482-1 and a (2-2)^{th} refractive layer 482-2. The (2-1)^{th} refractive layer 482-1 may be disposed between the (1-1)^{th} refractive layer 481-1 and the (1-2)^{th} refractive layer 481-2. The (1-2)^{th} refractive layer 481-2 may be disposed between the (2-1)^{th} refractive layer 482-1 and the (2-2)^{th} refractive layer 482-2. However, the second color layer according to an embodiment disclosed herein may include only the first refractive layer 481.

The following table may show, as an example, numbers of the first refractive layers 481 and the second refractive layers 482 and thicknesses of respective layers in an order of stacking that forms the second color layer 480.

**[Table 1]**

| Type | Thickness (nm) | Direction |
|---|---|---|
| First refractive layer | 372.62 | ↑ Toward outer side of housing |
| Second refractive layer | 68.96 | |
| First refractive layer | 56.2 | ↓ Toward inner side of housing |
| Second refractive layer | 77.99 | |
| First refractive layer | 46.61 | |
| Second refractive layer | 106.53 | |
| First refractive layer | 38.51 | |
| Second refractive layer | 78.64 | |
| First refractive layer | 172.67 | |
| Second refractive layer | 31.91 | |
| First refractive layer | 336.24 | |
| Second refractive layer | 20 | |

According to an embodiment, an angle of light incident on the glass layer 410 after passing through the second color layer 480 may vary depending on an angle at which light is incident on the second color layer 480. Light outside the cover 400 may be incident toward the second color layer 480 at a first angle α1. The first refractive layer 481 may form an outermost layer of the cover 400. The first refractive layer 481 may have a first thickness t1, and the second refractive layer 482 may have a second thickness t2. The thickness t1 of the first refractive layer 481 forming the outermost layer may be smaller than the thickness t2 of the second refractive layer 482. Light may be incident on the first refractive layer 481. Light incident at the first angle α1 may be refracted in the first refractive layer 481 and may travel at a first refraction angle β1. Light incident on the first refractive layer 481 may sequentially pass through the alternately stacked second refractive layers 482 and first refractive layers 481. Light incident on the first refractive layer 481 may travel with different incident angles α2 and α3 and different refraction angles β2 and β3 at boundaries of the respective layers 481 and 482. Light that has passed through the second color layer 480 may be incident toward the glass layer 410. Light that has passed through the second color layer 480 may have an incident angle α at a boundary between the glass layer 410 and the second color layer 480. The incident angle α may vary depending on the first angle α1 at which the light is incident on the second color layer 480. According to an embodiment, a layer forming a boundary between the second color layer 480 and the glass layer 410 may be the first refractive layer 481. A refractive index of the first refractive layer 481 may be greater than a refractive index of the glass layer 410. A portion of light that has passed through the second color layer 480 may be reflected at a boundary between the first refractive layer 481 and the glass layer 410 and may travel along a first path P1. According to an embodiment, light (e.g., visible light) incident on the second color layer 480 may be dispersed into respective wavelength regions while passing through the first refractive layer 481 and the second refractive layer 482. The light may implement different colors depending on wavelength regions, and light having different wavelength regions may have different refractive indices. At a boundary between two media (e.g., the first refractive layer 481 and the glass layer 410), light in some wavelength regions may be reflected, and light in remaining wavelength regions may be refracted. Light of some wavelength regions reflected at the boundary between two media (e.g., the first refractive layer 481 and the glass layer 410) may travel (e.g., along the path P1) with different incident angles (e.g., α4, α5, and α6) and refraction angles (e.g., β4 and β5) at boundaries between the first and second refractive layers 481 and 482. Light of some wavelength regions reflected at the boundary between two media (e.g., the first refractive layer 481 and the glass layer 410) may pass through the first refractive layer 481 forming an outermost layer and may travel (e.g., along the path P1) to outside the cover 400 with a refraction angle β6. Reflection at a boundary between two media may also occur at boundaries between the first refractive layers 481 and the second refractive layers 482. Light of the remaining wavelength regions refracted at the boundary between two media (e.g., the first refractive layer 481 and the glass layer 410) may travel (e.g., along the path P2) in a direction toward an inner side of the housing (e.g., the housing 310 of FIG. 5). According to an embodiment, a user may recognize light that is reflected at a boundary between two media (e.g., the first refractive layer 481 and the glass layer 410) and travels toward an outer side of the housing (e.g., the housing 301 of FIG. 5). As described above, according to an embodiment of the disclosure, due to a structure in which the first refractive layers 481 and the second refractive layers 482 are alternately stacked, light may be dispersed inside the second color layer 480 and may form different traveling paths (e.g., P1 and P2) depending on respective wavelength regions. Depending on the thicknesses t1 and t2 of the first and second refractive layers 481 and 482 and the number of stacked layers 481 and 482, a color of light that is reflected in the second color layer 480 and travels toward an outer side of the housing (e.g., the housing 301 of FIG. 5) may be adjusted.

According to an embodiment, traveling paths of light dispersed by respective wavelength regions may vary depending on an angle α1 at which the light is incident on the second color layer 480. Due to the above-described phenomenon in which the traveling path of light varies, a color of light recognized by a user may vary depending on an angle at which the user observes the cover 400.

FIG. 9 is a conceptual view for explaining a manufacturing process of the second color layer 480. The components to be described with reference to FIG. 9 may be partially or wholly the same as the components to be described with reference to FIGS. 1 to 8. Components described with reference to FIG. 9 may be partially or entirely the same as components to be described with reference to FIGS. 10A to 14.

According to an embodiment, the second color layer 480 may be manufactured by an inductive coupled plasma (ICP) sputtering method. The ICP sputtering method may be a method in which a silicon target is sputtered with argon (Ar) plasma and deposited on glass, and the glass on which the silicon target is deposited is transferred to an ICP plasma zone so as to be exposed to high-energy nitrogen plasma for nitridation. For example, referring to FIG. 9, at a first position P1, a process of sputtering a silicon target with argon (Ar) plasma and depositing the silicon on glass may be performed. The silicon deposit generated at the first position P1 may be transferred to a second position P2 by rotation R of a drum P3. The silicon deposit transferred to the second position P2 may be exposed to high-energy plasma and may be nitrided or oxidized. The first refractive layer 481 may be formed by nitriding, with high-energy nitrogen plasma, the silicon deposit transferred to the second position P2. The second refractive layer 482 may be formed by oxidizing, with high-energy oxygen plasma, the silicon deposit transferred to the second position P2. The second color layer 480 may be formed by alternately repeating nitridation and oxidation of the silicon deposit while rotating the drum P3.

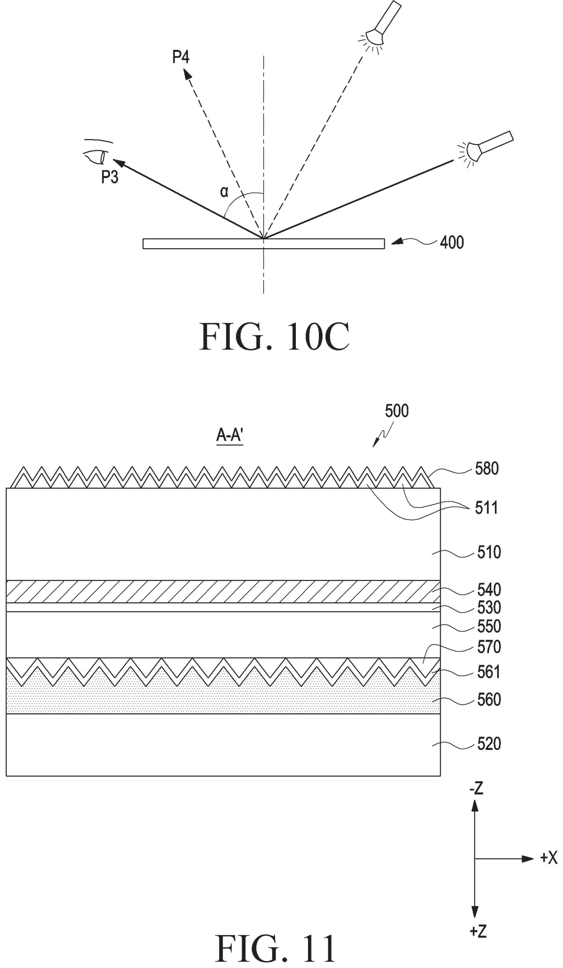

FIG. 10A is a view illustrating complementary relationships among various colors. FIG. 10B is a view illustrating an apparent color of the second color layer 480 according to a user's viewing angle. FIG. 10C is a view illustrating light traveling paths and light identified by a user. Components to be described with reference to FIGS. 10A, 10B, and 10C may be partially or entirely the same as components described with reference to FIGS. 1 to 9. Components to be described with reference to FIGS. 10A, 10B, and 10C may be partially or entirely the same as components to be described with reference to FIGS. 11 to 14.

According to an embodiment, a first color layer (e.g., at least one of the color tint layer 430, the polymer layer 450, and the color-printed layer 460 of FIG. 4) may have a first color C1. The first color C1 may be a red color. The second color layer 480 may have a second color C2 that is in a complementary color relationship S1 with the first color C1. The second color C2 may be a cyan color.

According to an embodiment, a type of color identified by a user may vary depending on a user's viewing angle θ. The user's viewing angle θ may be defined as an angular displacement from an axis Z perpendicular to a region of the cover 400 as an observed target to a position of the user's eye. A user may detect light of wavelength regions traveling along different paths (e.g., the path P3 of FIG. 10C) depending on the viewing angle θ.

According to an embodiment, the cover 400 may be observed as a color similar to the second color C2 as the viewing angle θ decreases. For example, when the viewing angle θ is 0 degrees, the cover 400 may be observed as the second color C2. As the viewing angle θ decreases, a ratio of light reflected from the second color layer 480 to light reflected from the first color layer (e.g., at least one of the color tint layer 430, the polymer layer 450, and the color-printed layer 460 of FIG. 6) may increase. As the viewing angle θ increases, a ratio of light reflected from the second color layer 480 to light reflected from the first color layer (e.g., at least one of the color tint layer 430, the polymer layer 450, and the color-printed layer 460 of FIG. 6) may decrease. As the viewing angle θ decreases, the second color layer 480 may be observed as being emphasized more strongly than the first color layer, and as the viewing angle θ increases, the first color layer may be observed as being emphasized more strongly than the second color layer 480.

According to an embodiment, the cover 400 may be observed as a color in which the first color C1 and the second color C2 are mixed. The cover 400 may be observed as a color in which a mixing ratio of the first color C1 to the second color C2 increases as the viewing angle θ increases. For example, when the viewing angle θ is 60 degrees, the cover 400 may be observed as a third color C3. The third color C3 may be a color in which the first color C1 and the second color C2 are mixed. The third color C3 may be in a color relationship S2, rather than in a complementary color relationship S1, with the first color C1. The third color C3 may be a blue color. The cover 400 may exhibit variable colors (e.g., C2, C3, C4, C5, C6, C7, C8, C9, or C10) depending on the viewing angle θ. FIG. 10B may illustrate, as an example, a relationship of color variation according to a viewing angle θ.

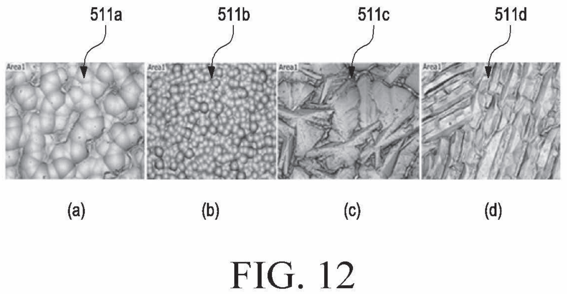

FIG. 11 is a partial cross-sectional view of the cover 500 of an embodiment of the disclosure illustrated in FIG. 5, taken along line A-A'. FIG. 12 is a view illustrating, as an example, a shape of the pattern 511 of FIG. 11. Components to be described with reference to FIGS. 11 and 12 may be partially or entirely the same as components described with reference to FIGS. 1 to 10C.

According to an embodiment, the housing (e.g., the housing 301 of FIG. 5) may include a cover 500. The description of the cover 400 described with reference to FIGS. 6 to 10C may be equally applied to the cover 500 of FIG. 11. For example, the cover 500 may include a shielding layer 520, a color tint layer 530, an adhesive layer 540, a polymer layer 550, a color-printed layer 560, a molded layer 561, and a deposition layer 570. Descriptions of the components (e.g., the shielding layer 420, the color tint layer 430, the adhesive layer 440, the polymer layer 450, the color-printed layer 460, the molded layer 461, and the deposition layer 470) described with reference to FIGS. 6 to 10C may be equally applied to the above-mentioned components (e.g., the shielding layer 520, the color tint layer 530, the adhesive layer 540, the polymer layer 550, the color-printed layer 560, the molded layer 561, and the deposition layer 570).

According to an embodiment, the cover 500 may include a glass layer 510 and a second color layer 580. The second color layer 580 may be deposited on one surface of the glass layer 510. According to an embodiment, the glass layer 510 may include a pattern 511. The pattern 511 may form a haze-processed surface of the glass layer 510. The pattern 511 may include at least one of a first pattern 511a, a second pattern 511b, a third pattern 511c, and a fourth pattern 511d illustrated in FIG. 12. The pattern 511 may be formed to protrude from a surface of the glass layer 510. The pattern 511 may cause diffuse reflection at a boundary between the second color layer 580 and the glass layer 510. As a degree of haze processing of the pattern 511 increases, a color of the second color layer 580 may be observed as being emphasized more strongly than a color of the first color layer (e.g., at least one of the color tint layer 530, the polymer layer 550, and the color-printed layer 560).

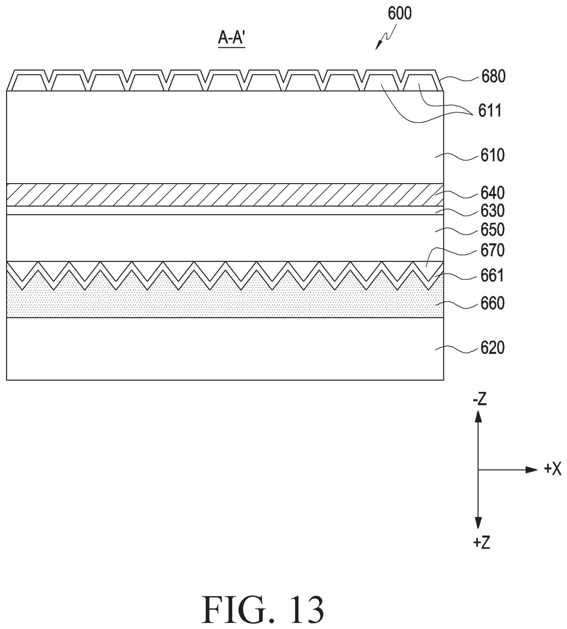

FIG. 13 is a partial cross-sectional view of a cover 600 of an embodiment of the disclosure illustrated in FIG. 5, taken along line A-A'. Components to be described with reference to FIG. 13 may be partially or entirely the same as components described with reference to FIGS. 1 to 10C.

According to an embodiment, the housing (e.g., the housing 301 of FIG. 5) may include a cover 600. The description of the cover 400 described with reference to FIGS. 6 to 10C may be equally applied to the cover 600 of FIG. 13. For example, the cover 600 may include a shielding layer 620, a color tint layer 630, an adhesive layer 640, a polymer layer 650, a color-printed layer 660, a molded layer 661, and a deposition layer 670. Descriptions of the components (e.g., the shielding layer 420, the color tint layer 430, the adhesive layer 440, the polymer layer 450, the color-printed layer 460, the molded layer 461, and the deposition layer 470) described with reference to FIGS. 6 to 10C may be equally applied to the above-mentioned components (e.g., the shielding layer 620, the color tint layer 630, the adhesive layer 640, the polymer layer 650, the color-printed layer 660, the molded layer 661, and the deposition layer 670).

According to an embodiment, the cover 600 may include a glass layer 610 and a second color layer 680. The second color layer 680 may be deposited on one surface of the glass layer 610. According to an embodiment, the glass layer 610 may include a pattern 611. The pattern 611 may form a haze-processed surface of the glass layer 610. The pattern 611 may be formed to protrude from a surface of the glass layer 610. The pattern 611 may cause diffuse reflection at a boundary between the second color layer 680 and the glass layer 610. As a degree of haze processing of the pattern 611 increases, a color of the second color layer 680 may be observed as being emphasized more strongly than a color of the first color layer (e.g., at least one of the color tint layer 630, the polymer layer 650, and the color-printed layer 660). According to an embodiment, the glass layer 610 may include a pattern 611 in which a stripe or argyle shape is patterned on a surface of the glass layer 610. The pattern 611 of the glass layer 610 may be fabricated through CNC machining. The pattern 611 of the glass layer 610 may be fabricated by a thermoforming method. In the thermoforming method, glass may be placed on a seating portion of a mold having a stripe or argyle shape and then pressed at a temperature of 700°C to 800°C under a pressure of 2.5 MPa.

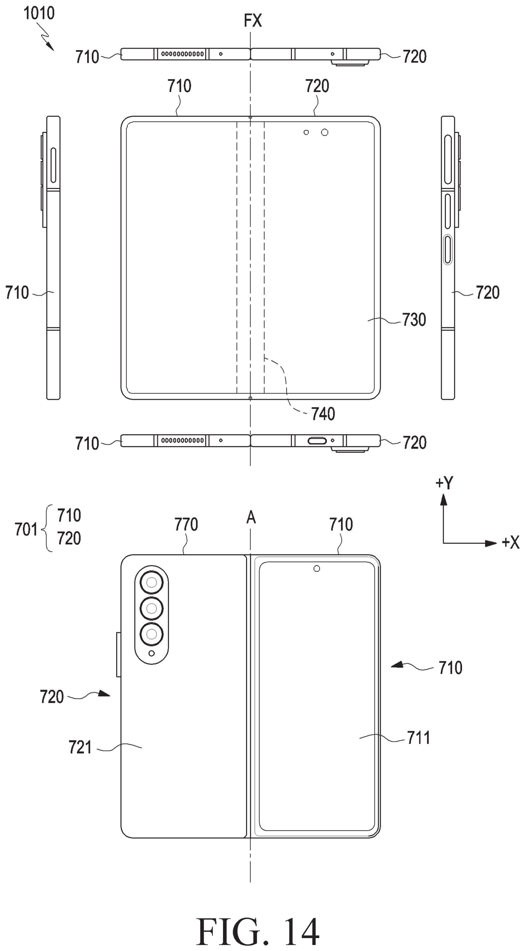

FIG. 14 is a view illustrating an electronic device 1010 according to an embodiment of the disclosure. The components to be described with reference to FIG. 14 may be partially or entirely the same as the components to be described with reference to FIGS. 1 to 13.

According to an embodiment, an electronic device 1010 may have a structure that is folded or unfolded about a folding axis FX. The electronic device 1010 may include a housing 701 including a first housing 710 and a second housing 720 rotatably coupled to the first housing 710. The electronic device 1010 may include a flexible display 730 disposed in the housing 701. The electronic device 1010 may include a hinge 740 that rotatably connects the first housing 710 and the second housing 720.

According to an embodiment, the electronic device 1010 may include covers 711 and 721 that form an exterior of the housing 701. The first housing 710 may include a first cover 711. The second housing 720 may include a second cover 721. The second cover 721 may form one surface of the housing 701. The second cover 721 may form an exterior of the housing 701. The second cover 721 may be the same as the cover 400 described with reference to FIGS. 6 to 10C. The second cover 721 may be the same as the cover 500 described with reference to FIGS. 11 and 12. The second cover 721 may be the same as the cover 600 described with reference to FIG. 13.

The electronic device includes a housing that forms an exterior and accommodates electronic components therein. The housing forms a surface of the electronic device that is identifiable to a user's eyes. User demand for the design of the housing is gradually increasing, and user interest in the color of the exterior is increasing.

A problem to be solved by the disclosure may be to implement a color that varies depending on a user's viewing angle.

A problem to be solved by the disclosure may be to provide a housing in which a reflective feeling is implemented.

The problems to be solved by the disclosure are not limited to the above-mentioned problems, and may be variously defined within a scope that does not depart from the spirit and scope of the disclosure.

An electronic device according to various embodiments of the disclosure may provide a cover having a color that varies depending on a viewing angle by disposing a first color layer and a second color layer in a complementary-color relationship.

An electronic device according to various embodiments of the disclosure may improve a reflective feeling of the cover by disposing a second color layer in which first refractive layers and second refractive layers are alternately stacked.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device (e.g., the electronic device 101 or 1010 of FIGS. 1 to 14) may include a display 220 or 320.

According to an embodiment of the disclosure, the electronic device (e.g., the electronic device 101 or 1010 of FIGS. 1 to 14) may include a housing 301 including a supporting member 311 on which the display 220 or 320 is seated and a cover 400, 500, or 600 forming at least a portion of an exterior of the electronic device.

According to an embodiment of the disclosure, the cover (e.g., the cover 400, 500, or 600 of FIGS. 6 to 13) may include a glass layer 410, 510, or 610.

According to an embodiment of the disclosure, the cover (e.g., the cover 400, 500, or 600 of FIGS. 6 to 13) may include a first color layer (e.g., the first color layer 430, 450, or 460, 530, 550, or 560, or 630, 650, or 660 of FIGS. 6 to 13) disposed between the glass layer (e.g., the glass layer 410, 510, or 610 of FIGS. 6 to 13) and the supporting member (e.g., the supporting member 311 of FIG. 5) and having a first color (e.g., the first color C1 of FIGS. 6 to 13).

According to an embodiment of the disclosure, the cover (e.g., the cover 400, 500, or 600 of FIGS. 6 to 13) may include a second color layer (e.g., the second color layer 480, 580, or 680 of FIGS. 6 to 13) disposed at a position opposite to the first color layer (e.g., the first color layer 430, 450, or 460, 530, 550, or 560, or 630, 650, or 660 of FIGS. 6 to 13) with respect to the glass layer (e.g., the glass layer 410, 510, or 610 of FIGS. 6 to 13) and having a second color (e.g., the second color C2 of FIGS. 6 to 13) that is complementary to the first color (e.g., C1 of FIGS. 6 to 13).

According to an embodiment of the disclosure, the second color layer (e.g., the second color layer 480 of FIGS. 6 to 13) may include multiple first refractive layers (e.g., the first refractive layers 481 of FIGS. 6 to 13) spaced apart from each other and having a first refractive index.

According to an embodiment of the disclosure, the second color layer (e.g., the second color layer 480 of FIGS. 6 to 13) may include multiple second refractive layers (e.g., the second refractive layers 482 of FIGS. 6 to 13) having a second refractive index smaller than the first refractive index and alternately stacked with the multiple first refractive layers (e.g., the first refractive layers 481 of FIGS. 6 to 13).

According to an embodiment of the disclosure, thicknesses of the first refractive layer (e.g., the first refractive layer 481 of FIGS. 6 to 13) and the second refractive layer (e.g., the second refractive layer 482 of FIGS. 6 to 13) may be different from each other.

According to an embodiment of the disclosure, at least one of the first refractive layer (e.g., the first refractive layer 481 of FIGS. 6 to 13) and the second refractive layer (e.g., the second refractive layer 482 of FIGS. 6 to 13) may have a refractive index greater than a refractive index of the glass layer (e.g., the glass layer 410 of FIGS. 6 to 13).

According to an embodiment of the disclosure, the first refractive layer (e.g., the first refractive layer 481 of FIGS. 6 to 13) may include a silicon nitride (Si₃N₄) material, and the second refractive layer (e.g., the second refractive layer 482 of FIGS. 6 to 13) may include a silicon oxide (SiO₂) material.

According to an embodiment of the disclosure, the second color layer (e.g., the second color layer 480 of FIGS. 6 to 13) may be deposited on one surface of the glass layer (e.g., the glass layer 410 of FIGS. 6 to 13).

According to an embodiment of the disclosure, the first color layer (e.g., the first color layer 430, 450, or 460 of FIGS. 6 to 13) may include at least one of a color tint layer (e.g., the color tint layer 430 of FIGS. 6 to 13) disposed between the glass layer (e.g., the glass layer 410 of FIGS. 6 to 13) and the supporting member (e.g., the supporting member 311 of FIG. 5), a polymer layer (e.g., the polymer layer 450 of FIGS. 6 to 13) disposed between the color tint layer (e.g., the color tint layer 430 of FIGS. 6 to 13) and the supporting member (e.g., the supporting member 311 of FIG. 5), and a color-printed layer (e.g., the color-printed layer 460 of FIGS. 6 to 13) disposed between the polymer layer (e.g., the polymer layer 450 of FIGS. 6 to 13) and the supporting member (e.g., the supporting member 311 of FIG. 5).

According to an embodiment of the disclosure, the cover (e.g., the cover 400 of FIGS. 6 to 13) may include a color-printed layer (e.g., the color-printed layer 460 of FIGS. 6 to 13) disposed between the glass layer (e.g., the glass layer 410 of FIGS. 6 to 13) and the supporting member (e.g., the supporting member 311 of FIG. 5) and forming a pattern protruding toward the glass layer (e.g., the glass layer 410 of FIGS. 6 to 13).

According to an embodiment of the disclosure, the cover (e.g., the cover 400 of FIGS. 6 to 13) may include a molded layer (e.g., the molded layer 461 of FIGS. 6 to 13) applied to the protruding pattern of the color-printed layer (e.g., the color-printed layer 460 of FIGS. 6 to 13).

According to an embodiment of the disclosure, the cover (e.g., the cover 400 of FIGS. 6 to 13) may include a deposition layer (e.g., the deposition layer 470 of FIGS. 6 to 13) applied to the color-printed layer (e.g., the color-printed layer 460 of FIGS. 6 to 13).

According to an embodiment of the disclosure, the glass layer (e.g., the glass layer 510 or 610 of FIGS. 6 to 13) may include a pattern (e.g., the pattern 511 or 611 of FIGS. 6 to 13) protruding toward the second color layer (e.g., the second color layer 580 or 680 of FIGS. 6 to 13).

According to an embodiment of the disclosure, the cover (e.g., the cover 400 of FIGS. 6 to 13) may include a shielding layer (e.g., the shielding layer 420 of FIGS. 6 to 13) disposed between the first color layer (e.g., the first color layer 430, 450, or 460 of FIGS. 6 to 13) and the supporting member (e.g., the supporting member 311 of FIG. 5).

According to an embodiment of the disclosure, the cover (e.g., the cover 400 of FIGS. 6 to 13) may include a reinforcing layer coupled to the second color layer (e.g., the second color layer 480 of FIGS. 6 to 13) and forming at least a portion of an external surface of the housing (e.g., the housing 301 of FIG. 5).

According to an embodiment of the disclosure, light reflected by the cover (e.g., the cover 400 of FIGS. 6 to 13) may have a mixed color of the first color (e.g., the first color C1 of FIGS. 6 to 13) and the second color (e.g., the second color C2 of FIGS. 6 to 13).

According to an embodiment of the disclosure, light reflected from the cover (e.g., 400 of FIGS. 6 to 13) according to an embodiment of the disclosure may have an increased mixing ratio of the second color (e.g., C2 of FIGS. 6 to 13) with respect to the first color (e.g., C1 of FIGS. 6 to 13) as a reflection angle (e.g., θ of FIGS. 6 to 13) of the light with respect to a direction (e.g., Z of FIGS. 6 to 13) perpendicular to an external surface of the housing (e.g., the housing 301 of FIG. 5) decreases.

According to an embodiment of the disclosure, the glass layer (e.g., the glass layer 510 or 610 of FIGS. 6 to 13) may include a pattern (e.g., the pattern 511 or 611 of FIGS. 6 to 13) formed at a boundary with the second color layer (e.g., the second color layer 580 or 680 of FIGS. 6 to 13) and haze-processed.

According to an embodiment of the disclosure, light reflected from the cover (e.g., 400 of FIGS. 6 to 13) may have an increased mixing ratio of the second color (e.g., C2 of FIGS. 6 to 13) with respect to the first color (e.g., C1 of FIGS. 6 to 13) as a degree of haze treatment of the pattern (e.g., 511 or 611 of FIGS. 6 to 13) increases. as a degree of haze treatment of the pattern (e.g., the pattern 511 or 611 of FIGS. 6 to 13) increases, a ratio at which the second color (e.g., the second color C2 of FIGS. 6 to 13) is mixed relative to the first color (e.g., the first color C1 of FIGS. 6 to 13) may increase.

In the foregoing detailed description of this document, specific embodiments have been described. However, it will be evident to a person ordinarily skilled in the art that various modifications can be made without departing from the scope of the disclosure.

## Claims

1. An electronic device (101; 1010) comprising:
a display (220, 320); and
a housing (301) including a supporting member (311) on which the display (220, 320) is seated and a cover (400; 500; 600) forming at least a portion of an external appearance of the electronic device (101; 1010),
wherein the cover (400; 500; 600) comprises:
a glass layer (410; 510; 610);
a first color layer (430, 450, 460; 530, 550, 560; 630, 650, 660) disposed between the glass layer (410; 510; 610) and the supporting member (311), and having a first color (C1); and
a second color layer (480; 580; 680) disposed opposite to the first color layer (430, 450, 460; 530, 550, 560; 630, 650, 660) with respect to the glass layer (410; 510; 610), and having a second color (C2), wherein the first color (C1) and the second color (C2) are complementary colors.

2. The electronic device of claim 1, wherein the second color layer (480) comprises:
a first refractive layer (481) having a first refractive index; and
a second refractive layer (482) having a second refractive index smaller than the first refractive index and stacked with the first refractive layer (481).

3. The electronic device of claim 2, wherein a thickness of the first refractive layer (481) is different from a thickness of the second refractive layer (482).

4. The electronic device of any one of claims 2 and 3, wherein at least one of the first refractive layer (481) and the second refractive layer (482) has a refractive index greater than a refractive index of the glass layer (410).

5. The electronic device of any one of claims 2 to 4, wherein the first refractive layer (481) comprises a silicon nitride (Si₃N₄) material and the second refractive layer (482) comprises a silicon oxide (SiO₂) material.

6. The electronic device of one of claims 1 to 5, wherein the second color layer(480) is deposited on one surface of the glass layer (410).

7. The electronic device of any one of claims 1 to 6, wherein the first color layer (430, 450, 460) comprises:
at least one of a color tint layer (430) disposed between the glass layer (410) and the supporting member (311), a polymer layer (450) disposed between the color tint layer (430) and the supporting member (311), and a color-printed layer (460) disposed between the polymer layer (450) and the supporting member (311).

8. The electronic device of any one of claims 1 to 7, wherein the cover (400) comprises:
a color-printed layer (460) disposed between the glass layer (410) and the supporting member (311) and forming a pattern protruding toward the glass layer (410); and
a molded layer (461) formed on the protruded pattern of the color-printed layer (460).

9. The electronic device of any one of claims 1 to 8, wherein the cover (400) further comprises:
a color-printed layer (460) disposed between the glass layer (410) and the supporting member (311); and
a deposition layer (470) applied to the color-printed layer (460).

10. The electronic device of any one of claims 1 to 9, wherein the glass layer (510; 610) comprises a pattern (511; 611) protruding toward the second color layer (580; 680).

11. The electronic device of any one of claims 1 to 10, wherein the cover (400) further comprises a shielding layer (420) disposed between the first color layer (430, 450, 460) and the supporting member (311).

12. The electronic device of any one of claims 1 to 11, wherein the cover (400) further comprises a reinforcing layer coupled to the second color layer (480), and forming at least a portion of an external surface of the housing (301).

13. The electronic device of any one of claims 1 to 12, wherein light reflected by the cover (400) has a mixed color of the first color (C1) and the second color (C2).

14. The electronic device of claim 13, wherein a mixing ratio of the second color (C2) to the first color (C1) increases as a reflection angle with respect to a direction (Z) perpendicular to an external surface of the housing (301) becomes smaller.

15. A cover (400; 500; 600) forming an exterior of an electronic device (101; 1010), the cover comprising:
a glass layer (410; 510; 610);
a first color layer (430, 450, 460; 530, 550, 560; 630, 650, 660) disposed on one side of the glass layer (410; 510; 610) and having a first color (C1); and
a second color layer (480; 580; 680) disposed opposite to the first color layer (430, 450, 460; 530, 550, 560; 630, 650, 660) with respect to the glass layer (410; 510; 610), and having a second color (C2),wherein the first color (C1) and the second color (C2) are complementary colors.
